# EUROPEAN PATENT SPECIFICATION

(11) **EP 0 784 342 B1**
(45) Date of publication and mention of the grant of the patent: **24.11.1999**
(21) Application number: 97104435.9
(22) Date of filing: 25.07.1994
(51) Int. Cl.: H01L 23/48, H01L 23/367, H01L 25/07

(54) **Pressure contact type semiconductor device and assembly method therefor**
Halbleiterbauelement mit Druckkontakt und dessen Montage
Dispositif semi-conducteur du type de contact à pression et son procédé de montage

(30) Priority: 27.07.1993 JP 18427193; 28.02.1994 JP 2862394
(43) Date of publication of application: 16.07.1997
(62) Divisional of application: 94305463.5
(73) Proprietor: FUJI ELECTRIC CO. LTD., Kawasaki 210 (JP)
(72) Inventor: Takahashi, Yoshikazu, Kawasaki-ku, Kawasaki 210 (JP)
(74) Representative: Bridge-Butler, Alan James

(56) References cited:
- EP-A- 0 285 074
- EP-A- 0 428 916
- EP-A- 0 439 003
- EP-A- 0 476 661
- EP-A- 0 499 707
- US-A- 4 313 128

## Description

The present invention relates to a pressure contact type semiconductor device, such as an insulated-gate bipolar transistor (IGBT) module, in which a plurality of semiconductor chips each having a first main electrode (emitter) and a control electrode (gate) on one principal surface of a substrate and a second main electrode (collector) on another principal surface. The invention also relates to an assembling method for such a semiconductor device.

The above-mentioned IGBT is widely applied as a power switching device to a motor PWM control inverter etc. With the increase of the size of semiconductor chips, the capacity of the IGBT has been further increased. Recently, to increase the capacity, a module structure in which a plurality of IGBTs are incorporated in a single package has been widely adopted.

In a MOS control device such as an IGBT, an emitter electrode as a main electrode and a gate electrode as a control electrode are formed side by side on one principal surface of a semiconductor chip. Because of this structure, when a device is assembled by packaging an IGBT chip, a collector on a second principal surface side can be directly mounted on a metal base that also serves as a heat radiator, but the emitter electrode and the gate electrode on the first principal surface side need to be connected to the exterior separately through external lead terminals. Therefore, in a conventional package assembly structure, in addition to the metal base, external lead terminals for the emitter and gate are provided on the top face of a package case. The connections between the emitter electrode and the external lead terminal, and between the gate electrode and the external electrode, are usually effected by wire bonding using an aluminium wire of about 300 µm in diameter.

EP-A-0 499 707 describes a semiconductor device wherein a plurality of semiconductor chips each having a first main electrode and a control electrode on a first principal surface and a second main electrode on a second principal surface are incorporated in a flat package formed by interposing an insulating outer frame between a pair of common electrode plates with the joints sealed, and wherein contact terminal bodies are interposed between the first main electrodes of the respective semiconductor chips and the common electrode plate of the package opposed thereto, the control electrodes of the respective semiconductor chips are wire-connected to a control electrode wiring conductor that is provided on an inner periphery of the package, and an external lead terminal for the control electrodes is led outside of the package through the wiring conductor.

Where a pressure contact type flat package is adopted in a composite device in which an IGBT and an attached flywheel diode are incorporated together in a single package to constitute a composite device, there arises the problem that the chip heights (wafer thicknesses) of the IGBT and the flywheel diode, which are determined by their electrical characteristics, are different from each other. When these different types of semiconductor chips having different heights are incorporated in a single flat package so as to be placed adjacent to each other, there occurs a difference in the chip top face height, that is, the electrode surfaces of two adjacent semiconductor chips form a step that is opposed to the flat electrode plate which is to be brought in common plane contact with the respective semiconductor chips of the flat package if no proper countermeasure is introduced. This step makes it very difficult to attain uniform pressure contact. It is known from experiments etc. that in this case if the difference between the heights of the semiconductor chips is not made within ±50µm, the heat dissipation performance and the electrical characteristics of the semiconductor device are much reduced.

More specifically, while conventional IGBTs generally use a wafer (called "epitaxial wafer") that is formed by sequentially growing n⁺ and n⁻ layers on a p⁺ silicon substrate by epitaxy to attain desired switching characteristics, flywheel diodes use a wafer that is formed by growing an n⁺ layer by epitaxy on an n⁻ silicon substrate that is produced by the FZ or MCZ method to produce the wafer at a lower cost. In these epitaxial wafers and FZ or MCZ wafers, the thickness of the n⁻layer is set at such an optimum value as provides the desired operating characteristics.

In the epitaxial wafer employed in the IGBT, a highly doped substrate is employed as the p⁺ silicon substrate to make its resistance so small as to be irrelevant to the saturation voltage, and the thickness of the p⁺ substrate is so set as to secure the necessary mechanical strength. On the other hand, in the diode using the FZ or MCZ wafer, the n⁺ epitaxial layer formed on the n⁻ silicon substrate is thin and, therefore, the total thickness of the substrate is substantially solely determined by the thickness of the n⁻ layer. As a result, in general, the IGBT chip has a greater wafer thickness and thus larger height than the flywheel diode chip, and the chip heights are not equal to each other when they are placed adjacent to each other on a flat electrode plate for assembling. That is, a level difference occurs between the top faces of the chips.

The present invention has been made in view of the above circumstances. With respect to a pressure contact type semiconductor device in which, as mentioned above, a plurality of IGBTs are incorporated in a flat package to constitute a module, a first object of the invention is to provide a pressure contact type semiconductor device having improved heat dissipation performance and small internal wiring inductance and, in particular. a package assembly structure therefor. With respect to a composite device in which IGBTs and flywheel diodes are incorporated together in a single flat package, a second object of the invention is to provide a pressure contact type semiconductor device which enables uniform pressure contact between the semiconductor chips and a common electrode plate of the package by equalizing thicknesses and parallelisms of the respective semiconductor chips without reducing their operating performance characteristics.

In accordance with a first aspect of the invention, there is provided a method of producing a pressure contact type semiconductor device including the steps of arranging on a substrate a number of tubular positioning guides, placing a respective thermoplastic conductive sheet on the substrate within each guide, placing a semiconductor on each sheet and a terminal body on each semiconductor within each guide, and applying pressure to the terminal bodies using a flat pressure plate so as to deform the conductive sheets to such a degree that the surfaces of the terminal bodies remote from the semiconductors lie in the same plane.

In accordance with a second aspect of the invention, there is provided a pressure contact type semiconductor device in which a plurality of semiconductor chips each having a first main electrode and a control electrode on a first principal surface and a second main electrode on a second principal surface are incorporated in a flat package so as to be placed adjacent to each other, wherein the flat package comprises an insulating outer frame interposed between and sealingly attached to the opposing faces of a pair of common electrode plates, contact terminal bodies serving both as pressure members and as heat radiators being interposed between the first main electrodes of the respective semiconductor chips and the common electrode plate of the package opposed thereto, the control electrodes of the respective semiconductor chips being wire-connected to a control electrode wiring conductor that is provided on an inner periphery of the package, and an external lead terminal for the control electrodes is led from outside of the package through to the wiring conductor, characterised in that a substrate for electrodes is provided on the common electrode plate of the package opposed to the second principal surfaces of the respective semiconductor chips, recesses are formed around chip mounting areas on the substrate for electrodes, and positioning guides for holding the semiconductor chips and the contact terminal bodies in place are fitted in and fixed to the recesses.

The above pressure contact type semiconductor device may be assembled in specific forms described below.
(1) The second principal surfaces of the respective semiconductor chips, and the electrode plate opposed thereto, are bonded to each other by means of thermoplastic electrically conductive sheets such as solder sheets interposed therebetween.
(2) Reliefs for the conductive sheets of item (1) are formed in portions of the recesses of item (1).

In the above constitution, for each of the plurality of semiconductor chips incorporated in the flat package, the main electrode is brought in pressure contact with the contact terminal body that is interposed between the first principal surface side and the common electrode of the package opposed thereto so as to avoid interference with the control electrode, and that is in area contact with the main electrode. Thus, heat dissipation to the exterior can also be effected on the first pnncipal surface side through the contact terminal body, without exerting undue mechanical pressure on the control electrode structure of the semiconductor chip. Combined with the heat dissipation on the second principal surface side, the heat dissipation performance is greatly improved and an increase of the current capacity of the semiconductor device is obtainable. Further, since the main electrodes of the semiconductor chips are directly connected to the terminal bodies by area contact without using bonding wires, the internal wiring inductance is reduced as compared with the case of bonding wire connections. Since the control electrodes are wire-connected to the wiring conductor that is provided on the inner periphery of the package so as to surround the semiconductor chips, connection to the control electrodes can be effected laterally without causing interference with the contact terminal bodies that are in pressure contact with the main electrodes.

When the plurality of IGBTs or the IGBTs and the flywheel diodes are incorporated in the single package so as to be adjacent to each other, the thermoplastic conductive sheets such as solder sheets are interposed between the second principal surfaces of the respective semiconductor chips and the electrode plate opposed thereto, and in this temporarily assembled state the conductive sheets are heated and a pressing operation is effected on all the chips from the side of the first principal surfaces. As a result, the conductive sheets are plastically deformed so as to accommodate any differences in height between the IGBTs and the flywheel diodes and variations in height among the respective chips to thereby allow the top faces of the respective semiconductor chips to lie in a parallel coplanar array and thus effectively equalise the heights of those faces. Uniform pressure contact between the common electrode plate of the flat package and the respective semiconductor chips incorporated in the package is thereby achieved.

Further, in the above case, assembling guides made of an insulating material are incorporated in the package to position the semiconductor chips, the contact terminal bodies and the conductive sheets at their predetermined assembling positions, recesses being provided as the means for fixing the assembling guides in place. The recesses are formed in the conductive substrate provided on the common electrode plate of the package opposed to the second principal surfaces of the semiconductor chips, and the reliefs for accommodating bulging portions of the conductive sheets (solder sheets) due to their plastic deformation are formed in portions of the recesses. As a result, the respective parts such as the semiconductor chips and the contact terminal bodies can be assembled being stably held in place in the package while interference between respective adjacent semiconductor chips due to the plastic deformation of the conductive sheets is prevented.

An embodiment of the present invention will be hereinafter described with reference to the accompanying drawings, in which:
Figure 1 is a sectional view showing an assembly structure of a pressure contact type semiconductor device according to the invention; and
Figure 2 illustrates an assembly method for the semiconductor device having the configuration of Figure 1.

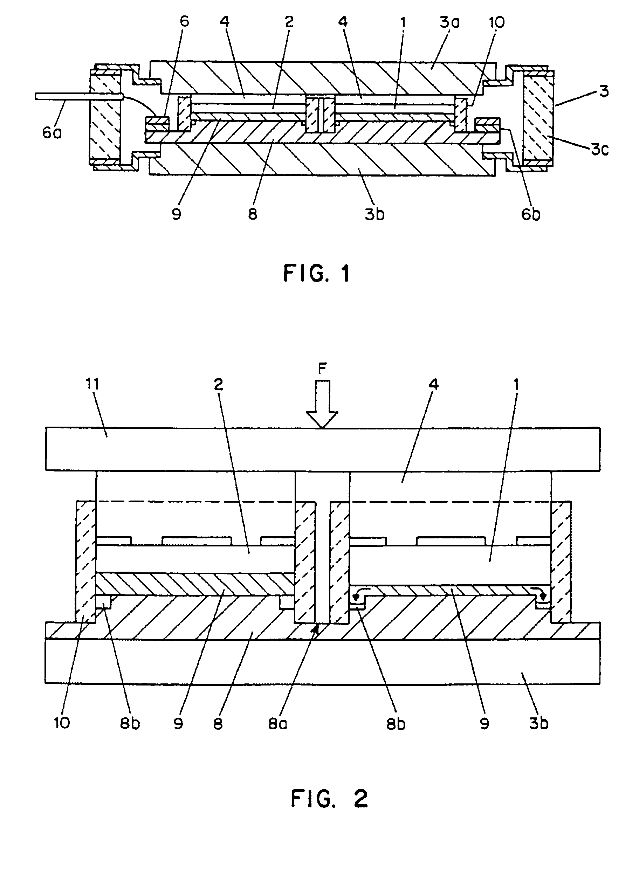

Referring now to the drawings, Figures 1 and 2 show a pressure contact type IGBT module in which an IGBT 1 and a flywheel diode 2 are placed adjacent to each other in a substantially coplanar array within a flat package. A pressure contact type flat package 3 encloses the IGBT 1 and the flywheel diode 2.

A silicon substrate of the IGBT 1 has a size of about 20 mm x 20 mm. The bottom principal face of the IGBT 1 (the underside as seen in Figure 1) is made the collector, and two strip-like emitter electrodes each having a width of about 2 mm and a length of about 16 mm are formed on the upper principal face (as seen in Figure 1) so as to avoid a gate structure with a gate electrode formed between the emitter electrodes. The flywheel diode 2 is placed adjacent to the IGBT 1 in the flat package 3 such that the top face and the bottom face of the silicon substrate are made the anode and cathode, respectively.

Figures 1 and 2 show an embodiment of the invention wherein a substrate 8 for collector electrodes is provided on the bottom common electrode plate 3b of the flat package 3, and is bonded to the IGBT 1 and the flywheel diode 2 through solder sheets 9 acting as thermoplastic conductive sheets. A wiring base for connecting the gate electrodes is provided in the periphery of the substrate 8 for collector electrodes, and a gate wiring conductor 6 is formed on the wiring base. A lead terminal 6a is led outside from the gate wiring conductor 6 penetrating through the insulating outer frame 3c of the package 3.

The contact terminal body 4 is a rectangular plate made of a material, such as molybdenum, having superior thermal and electrical conductivity. While its top face is finished into a flat surface to contact the electrode plate 3a, the opposite face, intended to contact the IGBT 1, has two protruding strips that are to make area contact with the emitter electrodes of the IGBT 1. Further, recessed cutouts are formed in peripheral portions of the contact terminal body 4 to avoid contact with a wire leading from a gate electrode of the IGBT 1. The external dimensions of the contact terminal bodies 4 are determined in accordance with the chip sizes of the IGBT 1 and the flywheel diode 2, and their thicknesses are the same.

Assembling or positioning guides 10 for a positioning purpose are incorporated in the package 3, and serve to hold the respective parts such as the semiconductor chips, the contact terminal bodies 4 and the solder sheets 9 in place. The assembling guides 10 are frames made of an insulating material, and each surrounds the respective chip of the IGBT 1 and the flywheel diode 2. The bottom ends of the assembling guides 10 are fitted in recesses 8a that are peripheral grooves carved in the top face of the substrate 8 for collector electrodes so as to be fixed and supported in place in an erected state. One-step shallower grooves to become solder reliefs 8b are formed in the recesses 8a along their inner circumferences.

Next, an assembling method of the above configuration will be described with reference to Figure 2. First, the assembling guides 10 are fixed in an erected state by fitting them into the recesses 8a in the respective semiconductor chip mounting portions defined in relation to the substrate 8 for collector electrodes. The solder sheets 9 are then laid on the substrate 8 within the assembling guides 10. IGBT 1 and the flywheel diode 2 are then placed on respective solder sheets 9. The contact terminal bodies 4 are finally inserted into the assembling guides 10, to rest on the semiconductor chips 1 or 2. A flat pressure plate 11 is put on all the contact terminal bodies 4. The above assembly is pressed with a predetermined pressing force F exerted on the pressing plate 11, while the solder sheets are externally heated to a softening temperature.

As a result, the solder sheets 9 are deformed plastically to accommodate any differences between the chip thicknesses of the IGBT 1 and the flywheel diode 2 and variations in thickness among the respective semiconductor chips, so that the top faces of the contact terminal bodies placed on the IGBT 1 and the flywheel diode 2 are arranged in the same plane at the same height and, at the same time, the respective chips are soldered to the substrate 8 for collector electrodes. In this operation, excessive portions of the solder sheets 9 that are squeezed out of the chip surface areas by the pressing operation go into the aforementioned solder reliefs 8b without causing any trouble. Where the chip thicknesses of the IGBT 1 and the flywheel diode 2 are different, a larger amount of excessive solder sheet bulges out on the side of whichever of the IGBT or flywheel diode has a larger chip thickness.

Thereafter, the insulating outer frame 3c of the flat package 3 is attached to the above assembly, and the gate electrode leading portion for the IGBT 1 is constructed. The common electrode plate 3a is then placed on the contact terminal bodies 4, and the insulating outer frame 3c is joined to the common electrodes with the joints sealed, to constitute a flat package with a hermetically sealed structure.

Actual sample products of the flat package type IGBT composite module that were assembled according to the above-described assembling method were subjected to an examination. It was found that variations in height among respective chips are all within an allowable range of ±50 µm.

The assembly method of Figure 2 using the solder sheets can also be applied to other semiconductor types. Although the above embodiment is directed to an IGBT module, it goes without saying that the invention can also be embodied similarly in a pressure contact type semiconductor device in which semiconductor elements having a control electrode other than the IGBT, for instance, MOS transistors and MOS-controlled thyristors, are combined and incorporated in a flat package.

As described above, the invention provides the advantage that the composite device that is assembled such that the IGBT and the flywheel diode are incorporated in the flat package as described, the first principal surfaces of all the chips can be arranged to be in the same plane at the same height in the state that the IGBT and the flywheel diode are incorporated and arranged in the flat package. As a result, uniform pressure contact can be obtained between the IGBT and flywheel diode and the common electrode plate of the package through the contact terminal bodies, to further improve reliability.

## Claims

1. A method of producing a pressure contact type semiconductor device including the steps of arranging on a substrate (8) a number of tubular positioning guides (10), placing a respective thermoplastic conductive sheet (9) on the substrate (8) within each guide (10), placing a semiconductor (1, 2) on each sheet (9) and a terminal body (4) on each semiconductor (1, 2) within each guide (10), and applying pressure to the terminal bodies using a flat pressure plate so as to deform the conductive sheets (9) to such a degree that the surfaces of the terminal bodies (4) remote from the semiconductors (1, 2) lie in the same plane.

2. A pressure contact type semiconductor device in which a plurality of semiconductor chips (1) each having a first main electrode and a control electrode on a first principal surface and a second main electrode on a second principal surface are incorporated in a flat package (3) so as to be placed adjacent to each other, wherein the flat package comprises an insulating outer frame (3c) interposed between and sealingly attached to the opposing faces of a pair of common electrode plates (3a, 3b), contact terminal bodies (4) serving both as pressure members and as heat radiators being interposed between the first main electrodes of the respective semiconductor chips (1) and the common electrode plate (3a) of the package opposed thereto, the control electrodes of the respective semiconductor chips (1) being wire-connected to a control electrode wiring conductor (6) that is provided on an inner periphery of the package, and an external lead terminal (6a) for the control electrodes is led from outside of the package through to the wiring conductor, characterised in that a substrate (8) for electrodes is provided on the common electrode plate (3b) of the package opposed to the second principal surfaces of the respective semiconductor chips (1), recesses (8a) are formed around chip mounting areas on said substrate (8), and positioning guides (10) for holding the semiconductor chips (1) and the contact terminal bodies (4) in place are fitted in and fixed to the recesses (8a).

3. A pressure contact type semiconductor device according to claim 2, characterised in that the second principal surfaces of the respective semiconductor chips (1) and the electrode plate (3b) opposed thereto are bonded to each other through thermoplastic conductive sheets (9) such as solder sheets interposed therebetween.

4. A pressure contact type semiconductor device according to claim 3, characterised in that reliefs (8b) for the conductive sheets (9) are formed in portions of the recesses (8a).

5. A pressure contact type semiconductor device according to any of claims 2, 3 or 4, characterised in that the top faces of the contact terminal bodies (4) are flat surfaces to contact the electrode plate (3a), while the opposite faces of the contact terminal bodies (4) intended to contact the respective semiconductor chips (1), have two protruding strips to make area contact with the main electrodes of the semiconductor chips (1).

## Patentansprüche

1. Verfahren zur Herstellung eines Halbleiterbauelements mit Druckkontakt, umfassend die Schritte des Anordnens einer Anzahl rohrförmiger Positionierführungen (10) auf einem Substrat (8), Plazieren eines entsprechenden thermoplastischen leitenden Blechs (9) innerhalb jeder Führung (10) auf dem Substrat (8), Plazieren eines Halbleiters (1, 2) auf jedem Blech (9) und eines Anschlußkörpers (4) auf jedem Halbleiter (1, 2) innerhalb jeder Führung (10) und Anlegen eines Drucks auf die Anschlußkörper unter Verwendung einer flachen Druckplatte, um die leitenden Bleche (9) in einem solchen Maß zu deformieren, daß die Oberflächen der Anschlußkörper (4), die von den Halbleitern (1, 2) entfernt sich befinden, in der gleichen Ebene liegen.

2. Halbleitervorrichtung mit Druckkontakt, bei welcher mehrere Halbleiterchips (1), die jeweils eine erste Hauptelektrode und eine Steuerelektrode an einer ersten Hauptfläche und eine zweite Hauptelektrode in einer zweiten Hauptfläche aufweisen, in einem flachen Gehäuse (3) eingebaut sind, um nebeneinander plaziert zu sein, wobei das flache Gehäuse (3) umfaßt einen isolierenden äußeren Rahmen (3c), der zwischen angeordnet und abgedichtet befestigt ist an einander gegenüberliegenden Flächen von zwei gemeinsamen Elektrodenplatten (3a, 3b) Kontaktanschlußkörper (4), die sowohl als Druckkörper als auch als Wärmeradiatoren dienen, zwischen den ersten Hauptelektroden der entsprechenden Halbleiterchips (1) und der gemeinsamen Elektrodenplatte (3a) des Gehäuses dazu gegenüberliegend angeordnet sind, die Steuerelektroden der entsprechenden Halbleiterchips (1) über Drahtverbindungen mit einem Steuerelektrodenverdrahtungsleiter (6) verbunden sind, der an der inneren Peripherie des Gehäuses vorgesehen ist, und einen externen Leitungsanschluß (6a) für die Steuerelektroden, der durch den Verdrahtungsleiter von der Außenseite des Gehäuses geführt ist, **dadurch gekennzeichnet,** daß ein Substrat (8) für die Elektroden an der gemeinsamen Elektrodenplatte (3b) des Gehäuses gegenüber den zweiten Hauptflächen der entsprechenden Halbleiterchips (1) vorgesehen ist, Vertiefungen (8a) um die Chipbefestigungsbereiche des Substrats (8) angeformt sind und Positionierführungen (10) zum Halten der Halbleiterchips (1) und der Kontaktanschlußkörper (4) an Ort und Stelle in die Vertiefungen (8a) eingepaßt und fixiert sind.

3. Halbleitervorrichtung mit Druckkontakt nach Anspruch 2, **dadurch gekennzeichnet,** daß die zweiten Hauptflächen der entsprechenden Halbleiterchips (1) und die dazu gegenüberliegende Elektrodenplatte (3b) miteinander durch ein thermoplastisches leitendes Blech (9), wie beispielsweise ein dazwischen angeordnetes Lötblech, miteinander verbunden sind

4. Halbleitervorrichtung mit Druckkontakt nach Anspruch 3, **dadurch gekennzeichnet,** daß Aussparungen (8b) für die leitenden Bleche (9) an Teilen der Vertiefungen (8a) angeformt sind.

5. Halbleitervorrichtung mit Druckkontakt nach einem der Ansprüche 2, 3 oder 4, **dadurch gekennzeichnet,** daß die oberen Flächen der Kontaktanschlußkörper (4) flache Oberflächen zum Kontakt mit der Elektrodenplatte (3a) sind, während die gegenüberliegenden Flächen der Kontaktanschlußkörper (4) zum Kontakt mit entsprechenden Halbleiterchips (1) vorgesehen sind, welche zwei vorspringende Streifen zur Herstellung eines Flächenkontakts mit den Hauptelektroden der Halbleiterchips (1) aufweisen.

## Revendications

1. Procédé de production d'un dispositif à semi-conducteurs du type à contact par pression comportant les étapes consistant à agencer sur un substrat (8) plusieurs guides de positionnement tubulaires (10), placer une feuille thermoplastique conductrice (9) respective sur le substrat (8) dans chaque guide (10), placer un semi-conducteur (1, 2) sur chaque feuille (9) et un corps de borne (4) sur chaque semi-conducteur (1, 2) dans chaque guide (10), et appliquer une pression sur les corps de borne en utilisant une plaque d'appui plate de manière à déformer les feuilles conductrices (9) sur une amplitude telle que les surfaces des corps de borne (4) éloignées des semi-conducteurs (1, 2) se trouvent dans le même plan.

2. Dispositif à semi-conducteurs du type à contact par pression dans lequel une pluralité de puces semi-conductrices (1) ayant chacune une première électrode principale et une électrode de commande sur une première surface principale et une seconde électrode principale sur une seconde surface principale sont incorporées dans un boîtier plat (3) de manière à être placées adjacentes l'une à l'autre, le boîtier plat comportant un châssis extérieur isolant (3c) interposé entre les faces opposées de deux plaques d'électrode communes (3a, 3b) et relié de manière étanche à celles-ci, les corps de borne de contact (4) servant à la fois en tant qu'éléments d'appui et en tant que radiateurs thermiques interposés entre les premières électrodes principales des puces semi-conductrices respectives (1) et la plaque d'électrode commune (3a) du boîtier opposée à celles-ci, les électrodes de commande des puces semi-conductrices respectives (1) étant reliées par fil à un conducteur de câblage d'électrode de commande (6) qui est agencé sur une périphérie intérieure du boîtier, et une borne pour conducteur extérieur (6a) destinée aux électrodes de commande traverse le boîtier depuis l'extérieur jusqu'au conducteur de câblage, caractérisé en ce qu'un substrat (8) pour les électrodes est agencé sur la plaque d'électrode commune (3b) du boîtier opposée aux secondes surfaces principales des puces semi-conductrices respectives (1), des cavités (8a) étant formées autour des zones de montage de puce sur ledit substrat (8) et des guides de positionnement (10) destinés à maintenir en position les puces semi-conductrices (1) et les corps de borne de contact (4) sont agencés dans les cavités (8a) et fixés dans celles-ci.

3. Dispositif à semi-conducteurs du type à contact par pression selon la revendication 2, caractérisé en ce que les secondes surfaces principales des puces semi-conductrices respectives (1) et la plaque d'électrode (3b) opposée à celles-ci sont fixées l'une à l'autre par l'intermédiaire de feuilles conductrices thermoplastiques (9) telles que des feuilles de soudure interposées entre elles.

4. Dispositif à semi-conducteurs du type à contact par pression selon la revendication 3, caractérisé en ce que des dépouilles (8b) pour les feuilles conductrices (9) sont formées dans des parties des évidements (8a).

5. Dispositif à semi-conducteurs du type à contact par pression selon l'une quelconque des revendications 2, 3, ou 4, caractérisé en ce que les faces supérieures des corps de borne de contact (4) sont des surfaces plates destinées à venir en contact avec la plaque d'électrode (3a) alors que les faces opposées des corps de borne de contact (4) prévues pour être en contact avec les puces semi-conductrices respectives (1) ont deux bandes en saillie pour constituer un contact superficiel avec les électrodes principales des puces semi-conductrices (1).
